# EUROPÄISCHE PATENTSCHRIFT

(11) **EP 1 310 002 B1**
(45) Veröffentlichungstag und Bekanntmachung des Hinweises auf die Patenterteilung: **06.06.2018**
(21) Anmeldenummer: 01962563.1
(22) Anmeldetag: 18.07.2001
(51) Int. Cl.: H01L 33/00

(54) **VERFAHREN ZUR HERSTELLUNG EINER VIELZAHL VON HALBLEITERCHIPS**
METHOD FOR MANUFACTURING A PLURALITY OF SEMICONDUCTOR CHIPS
PROCÉDÉ DE FABRICATION D'UNE PLURALITÉ DE PUCES À SEMICONDUCTEURS

(30) Priorität: 18.08.2000 DE 10040448
(43) Veröffentlichungstag der Anmeldung: 14.05.2003
(73) Patentinhaber: OSRAM Opto Semiconductors GmbH, 93055 Regensburg (DE)
(72) Erfinder: ILLEK, Stefan, 93093 Donaustauf (DE)
(74) Vertreter: Epping - Hermann - Fischer
(86) Internationale Anmeldenummer: PCT/DE2001/002702
(87) Internationale Veröffentlichungsnummer: WO 2002/015286

(56) Entgegenhaltungen:
- EP-A- 0 740 376
- EP-A- 0 810 674
- DE-A- 10 000 088
- FR-A- 2 538 616
- US-A- 3 728 236
- US-A- 4 095 330
- US-A- 4 350 990
- US-A- 5 144 413
- US-A- 5 401 983
- US-A- 5 862 167
- US-A- 5 919 713
- US-A- 5 998 238
- US-A- 6 060 730
- PATENT ABSTRACTS OF JAPAN vol. 010, no. 186 (E-416), 28. Juni 1986 (1986-06-28) & JP 61 034983 A (FUJITSU LTD), 19. Februar 1986 (1986-02-19)
- PATENT ABSTRACTS OF JAPAN vol. 1999, no. 08, 30. Juni 1999 (1999-06-30) & JP 11 068157 A (SUMITOMO ELECTRIC IND), 9. März 1999 (1999-03-09)

## Beschreibung

Die Erfindung betrifft ein Verfahren zur Herstellung einer Vielzahl von Halbleiterchips in Dünnschichttechnik. Derartige Halbleiterchips sind beispielsweise aus der EP 0 905 797 A2 bekannt. Die aktive Schicht dieser Halbleiterchips wird üblicherweise auf einem Substrat aufgewachsen. Das Substrat wird im allgemeinen einen Teil der von der aktiven Schicht emittierten Photonen absorbieren. Es ist daher bekannt, zur Steigerung der Lichtausbeute die aktive Schicht vom Substrat zu trennen und auf einen durch eine Reflexionsschicht von der aktiven Schicht getrennten Trägerkörper aufzubringen. Die Befestigung an einem Trägerkörper ist notwendig, um die notwendige mechanische Festigkeit in den nachfolgenden Prozeßschritten zu gewährleisten.

DE 10000088 A1 beschreibt Bauelemente und Verfahren zum Herstellen von lichtemittierenden InAlGaN-Bauelementen, die sich aus der Entfernung von lichtemittierenden Schich-ten von dem Saphirwachstumssubstrat ergeben.

JP H1168157 beschreibt ein lichtemittierendes Element mit einem leitfähigen Substrat aus einer Fe-Ni-Legierung und einem Au-Sn-Lot. Ein GaAs Aufwachssubstrat wird durch Nassätzen entfernt.

US 3,728,236 betrifft ein Verfahren zur Herstellung von Halbleitervorrichtungen, die auf Kühlkörper montiert sind, und insbesondere auf ein Verfahren zur Herstellung solcher Vorrichtungen, bei denen das Halbleitermaterial sehr dünn ist.

FR 2538616 bezieht sich auf Mikrowellenfrequenzdioden und auf deren Herstellungsverfahren. Eine Diode ist zwischen zwei übereinanderliegenden Schichten von Dielektrikum an-geordnet, die als Verkapselung dienen.

US 5,919,713 betrifft ein Verfahren zum Herstellen eines Halbleiterbauelements mit einer plattierten Wärmesenke.

US 4,095,330 beschreibt Prozesse zum Isolieren einzelner aktiver Halbleiterelemente voneinander, zum Anbringen solcher Elemente an einer thermischen Wärmesenke und zum Bilden elektrischer Verbindungen und Verbindungen zu und zwischen den Elementen, wobei die Prozesse als Niedertemperaturprozesse durchgeführt werden.

Ein Nachteil der bekannten Halbleiterchips ist, daß die Übertragung der aktiven Schicht vom Substrat auf den Trägerkörper schwierig zu handhaben ist. Insbesondere kann die Verbindung zwischen Trägerkörper und aktiver Schicht in allgemein nur durch die Anwendung von hohem mechanischem Druck oder erhöhter Temperatur bewerkstelligt werden. Beides kann für die aktive Schicht schädlich sein.

Ausgehend von diesem Stand der Technik liegt der Erfindung die Aufgabe zugrunde, ein zur Herstellung von Halbleiterchips geeignetes Verfahren zu schaffen.

Diese Aufgabe wird durch ein Verfahren mit den Merkmalen des Anspruchs 1 gelöst.

Durch die rückseitige Kontaktschicht, deren Dicke mindestens gleich der Dicke der aktiven Schicht ist, wird die aktive Schicht versteift. Das Aufbringen auf einen Trägerkörper für die weitere Behandlung der aktiven Schicht ist daher nicht notwendig. Außerdem können Kontaktschichten herkömmlicherweise mit üblichen Materialien in großer Dicke hergestellt werden. Um Kontaktschichten ausreichend dick herzustellen, brauchen daher nicht neue Verfahren entwickelt zu werden. Insgesamt ermöglicht die Erfindung daher eine wesentlich ver einfachte Herstellung von Halbleiterchips in Dünnschichttechnik.

Bei dem erfindungsgemäßen Verfahren wird nach dem galvanischen Aufbringen der Verstärkungsschicht auf der Grundschicht eine flächendeckende Hilfsträgerschicht auf der Verstärkungsschicht und der aktiven Schicht abgeschieden.

Durch solch eine Hilfsträgerschicht kann die aktive Schicht zu einem festen und starren Körper weitergebildet werden, der in seinen mechanischen Eigenschaften einem Wafer gleichkommt.

Bei einer bevorzugten Ausgestaltung des Verfahrens wird die Hilfsträgerschicht aus einem Material hergestellt, das selektiv gegenüber der Verstärkungsschicht entfernt werden kann.

Diese Materialwahl ermöglicht, die Halbleiterchips nach ihrer Verarbeitung in einzelne Halbleiterchips ohne Sägeprozesse zu vereinzeln. Dadurch fällt kein Materialverschnitt an und es ist nicht erforderlich, die Ungenauigkeiten beim Sägen durch eine entsprechende Gestaltung der Halbleiterchips zu berücksichtigen.

Weitere vorteilhafte Ausgestaltungen der Erfindung sind Gegenstand der abhängigen Ansprüche.

Nachfolgend wird die Erfindung im einzelnen anhand der beigefügten Zeichnung erläutert. Es zeigen:
- Figur 1: einen Querschnitt durch eine Schichtfolge mit einem Substrat und mit einer darauf aufgebrachten aktiven Schicht, die mit rückseitigen Kontaktstellen versehen ist;
- Figur 2: die Schichtfolge aus Figur 1, deren rückseitige Kontaktstellen mit einer Verstärkungsschicht verstärkt worden sind;
- Figur 3: die mit einer Hilfsträgerschicht versehene Schichtfolge aus Figur 2;
- Figur 4: die Schichtfolge aus Figur 3, nachdem das Substrat entfernt worden ist;
- Figur 5: einen Querschnitt durch die mit vorderseitigen Kontaktstellen versehene Schichtfolge aus Figur 4 nach der Chiptrennung;
- Figur 6: die auf eine Folie aufgebrachte Schichtfolge aus Figur 5; und
- Figur 7: einen Querschnitt durch die auf der Folie aufliegenden, vereinzelten Halbleiterchips nach Entfernen der Hilfsträgerschicht.

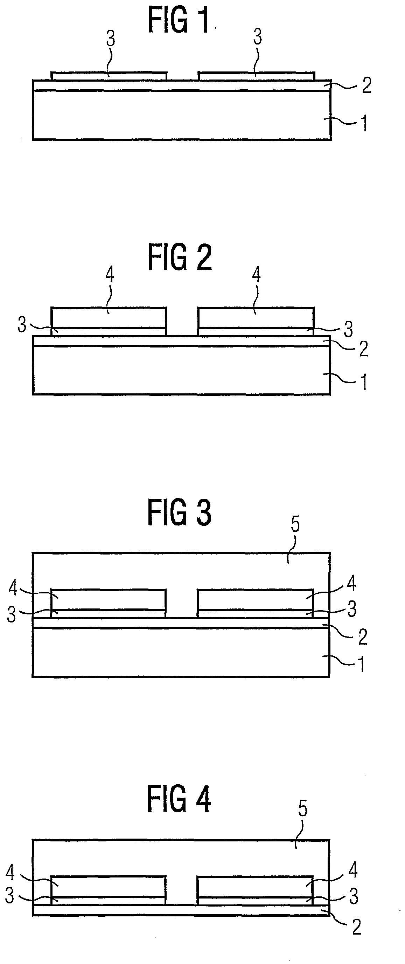

In Figur 1 ist ein Querschnitt durch eine Schichtfolge dargestellt, die ein Substrat 1 aufweist. Auf dem Substrat 1 ist eine aktive Schicht 2 aufgewachsen, die eine Photonen emittierende, aktive Zone umfaßt. Die Dicke der aktiven Schicht 2 liegt üblicherweise zwischen 5 bis 15µm.

Auf der aktiven Schicht 2 sind rückseitige Kontaktschichten ausgebildet, die im dargestellten Fall unter anderem über eine Grundschicht 3 verfügen. Über die Kontaktschichten kann Strom in die aktive Schicht 2 eingespeist werden.

In einem weiteren Verfahrensschritt wird gemäß Figur 2 auf die Grundschichten 3 eine Verstärkungsschicht 4 auf galvanischem Wege aufgebracht. Die Verstärkungsschicht 4 ist beispielsweise aus Gold gefertigt und weist eine Dicke von 20 bis 30µm auf.

Anschließend wird eine flächendeckende Hilfsträgerschicht 5 auf die Verstärkungsschicht 4 und die aktive Schicht 2 aufgebracht. Das Aufbringen der Hilfsträgerschicht 5 erfolgt beispielsweise ebenfalls auf galvanischem Wege.

Anschließend wird das Substrat 1 von der aktiven Schicht 2 getrennt. Damit ergibt sich der in Figur 4 gezeigte Querschnitt. Die Dicke der Hilfsträgerschicht 5 ist so bemessen, daß die in Figur 4 dargestellte Schichtenfolge eine ausreichende mechanische Festigkeit für die nachfolgenden Prozeßschritte bietet. Das Material für die Hilfsträgerschicht 5 ist ferner so gewählt, daß die Hilfsträgerschicht 5 selektiv zur Verstärkungsschicht 4 entfernt werden kann. Beispielsweise kann die Hilfsträgerschicht 5 aus Nickel oder Silber hergestellt werden, während die Verstärkungsschicht 4 aus Gold gefertigt ist. In diesem Fall kann die Hilfsträgerschicht 5 durch Ätzen mit Salpetersäure selektiv zur Verstärkungsschicht 4 entfernt werden.

In einem weiteren Verfahrensschritt werden auf der aktiven Schicht 2 vorderseitige Kontaktschichten 6 ausgebildet. Dann wird die aktive Schicht 2 durch einen Ätzprozeß durchtrennt. Dadurch entstehen einzelne Halbleiterchips 7. Der Ätzprozeß wird so geführt, daß sich die aktive Schicht 2 der Halbleiterchips 7 mit den von der Grundschicht 3 und der Verstärkungsschicht 4 gebildeten, rückseitigen Kontaktschichten deckt.

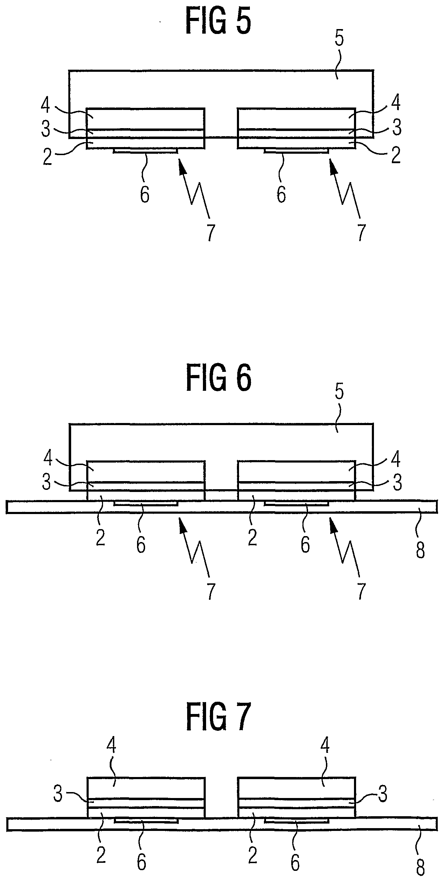

Um die Handhabung der Halbleiterchips 7 zu erleichtern, werden die Halbleiterchips 7 auf ihrer Vorderseite mit einer Folie 8 laminiert. Damit ergibt sich der in Figur 6 dargestellte Querschnitt durch die Schichtfolge.

Abschließend wird die Hilfsträgerschicht 5 selektiv gegenüber den Grundschichten 3 und den Verstärkungsschichten 4 entfernt. Es ergeben sich einzelne Halbleiterchips 7, die auf der Folie 8 aufgebracht sind.

Das beschriebene Verfahren bietet eine Reihe von Vorteilen.

Bei dem beschriebenen Verfahren wird der bei herkömmlichen Dünnschichtverfahren verwendete mechanische Trägerkörper durch die Verstärkungsschicht 4 ersetzt. Die Verstärkungsschicht 4 bietet dem Halbleiterchip 7 eine ausreichende mechanische Festigkeit, die es gestattet, die Halbleiterchips 7 bis zum Aufsetzen auf eine Leiterplatte zu handhaben.

Nach dem Entfernen des Substrats 1 bietet die Hilfsträgerschicht 5 einen ausreichenden Ersatz für einen mechanischen Träger für die Durchführung der zur Herstellung der Halbleiterchips 7 erforderlichen Waferprozeßschritt. Daher kann auf einen weiteren mechanischen Träger ganz verzichtet werden. Die Halbleiterchips 7 weisen ferner nur die für die Funktion unerläßlichen Komponenten auf: die aktive Schicht 2 sowie die von der Grundschicht 3 und der Verstärkungsschicht 4 gebildete, rückseitige Kontaktschichten und vorderseitige Kontaktschichten 6. Die Baugröße der Halbleiterchips 7 kann daher auch ohne weitere Schwierigkeiten verkleinert werden.

Für das Aufbringen der Hilfsträgerschicht 5 können galvanische Prozesse verwendet werden. Diese sind kostengünstige Standardverfahren. Außerdem können galvanische Schichten auch ohne große Probleme großflächig aufgebracht werden, ohne daß beispielsweise die Gefahr von Lufteinschlüssen wie beim Bonden großer Flächen besteht.

Weiterhin ist von Vorteil, daß das Vereinzeln der Halbleiterchips 7 durch Ätzprozesse erfolgt. Es braucht daher kein Sägeverfahren verwendet zu werden. Dadurch kann die Nutzung der aktiven Schicht 2 von 70% auf etwa 90% gesteigert werden, denn zum einen sind bei den Abmessungen der Halbleiterchips keine Sägetoleranzen zu berücksichtigen und zum anderen entfällt der Materialverschnitt von etwa 50µm pro Halbleiterchip 7.

Das vorgestellte Verfahren eignet sich insbesondere zur Herstellung von Halbleiterchips für Leuchtdioden hoher Leuchtdichte.

## Patentansprüche

1. Verfahren zur Herstellung einer Vielzahl von Halbleiterchips in Dünnschichttechnik mit den Verfahrensschritten:
- Ausbilden einer eine Photonen emittierende Zone aufweisenden aktiven Schicht (2) auf einem Substrat (1);
- Ausbilden von rückseitigen Kontaktschichten, die eine Grundschicht (3) auf der aktiven Schicht (2) und eine auf galvanischem Wege aufgebrachte Verstärkungsschicht (4) auf der Grundschicht (3) aufweisen und eine Dicke haben, die mindestens so groß ist wie die Dicke der aktiven Schicht (2),
- flächendeckendes Aufbringen einer Hilfsträgerschicht (5) auf die Verstärkungsschicht (4) und die aktive Schicht (2), und
- Entfernen des Substrats (1) nachfolgend auf das Aufbringen der Hilfsträgerschicht (5),
- Vereinzeln der aktiven Schicht (2) nach dem Entfernen des Substrats (1) in eine Vielzahl von Halbleiterchips (7), **dadurch gekennzeichnet, dass** nach dem Vereinzeln die Hilfsträgerschicht (5) entfernt wird.

2. Verfahren nach Anspruch 1, wobei die Hilfsträgerschicht (5) aus einem Material hergestellt ist, das selektiv gegenüber der Verstärkungsschicht (4) entfernbar ist.

3. Verfahren nach Anspruch 1 oder 2 ,
**dadurch gekennzeichnet,**
**dass** die Kontaktschichten (3, 4) mindestens die doppelte Dicke der aktiven Schicht (2) aufweisen.

4. Verfahren nach einem der Ansprüche 1 bis 3,
**dadurch gekennzeichnet, dass** die Hilfsträgerschicht (5) auf galvanischem Wege aufgebracht wird.

5. Verfahren nach einem der Ansprüche 1 bis 4,
**dadurch gekennzeichnet,**
**dass** nach dem Entfernen des Substrats (1) auf der der Hilfsträgerschicht (5) gegenüberliegenden Seite der aktiven Schicht (2) vorderseitige Kontaktschichten (6) ausgebildet werden.

6. Verfahren nach Anspruch 1,
**dadurch gekennzeichnet,**
**dass** die Halbleiterchips (7) vorderseitig auf eine Folie (8) aufgebracht werden.

## Claims

1. A method for producing a plurality of semiconductor chips in thin-film technology with the method steps:
- forming a photon emitting zone having active layer (2) on a substrate (1);
- forming back contact layers having a base layer (3) on the active layer (2) and a galvanically applied reinforcing layer (4) on the base layer (3) and having a thickness which is at least as large as the thickness of the active layer (2),
- area-covering application of a subcarrier layer (5) on the reinforcing layer (4) and the active layer (2), and
- removing the substrate (1) after the application of the subcarrier layer (5),
- separating the active layer (2) after removing the substrate (1) into a plurality of semiconductor chips (7),
**characterized in that** after separating the subcarrier layer (5) is removed.

2. The method of claim 1, wherein the subcarrier layer (5) is made of a material selectively removable from the reinforcing layer (4).

3. Method according to claim 1 or 2, **characterized in that** the contact layers (3, 4) have at least twice the thickness of the active layer (2).

4. Method according to one of claims 1 to 3, **characterized in that** the subcarrier layer (5) is applied by electroplating.

5. Method according to one of claims 1 to 4, **characterized in that** after removal of the substrate (1) front-side contact layers (6) are formed on the side of the active layer (2) opposite the auxiliary carrier layer (5).

6. Method according to claim 1, **characterized in that** the semiconductor chips (7) are applied with the front side on a foil (8).

## Revendications

1. Procédé de fabrication d'une pluralité de puces à semi-conducteur à technique à couche mince, comprenant les étapes de procédé :
- réalisation sur un substrat (1) d'une couche active (2) présentant une zone émettant des photons ;
- réalisation de couches de contact côté arrière, lesquelles présentent une couche de base (3) sur la couche active (2) et une couche de renforcement (4) appliquée par voie galvanique sur la couche de base (3) et lesquelles ont une épaisseur qui est au moins aussi grande que l'épaisseur de la couche active (2),
- application sur toute la surface d'une couche de support auxiliaire (5) sur la couche de renforcement (4) et sur la couche active (2), et
- enlèvement du substrat (1) après l'application de la couche de support auxiliaire (5)
- individualisation de la couche active (2), après l'enlèvement du substrat (1), en une pluralité de puces à semi-conducteur (7),
**caractérisé en ce que** la couche de support auxiliaire (5) est enlevée après l'individualisation.

2. Procédé selon la revendication 1, la couche de support auxiliaire (5) étant fabriquée dans une matière qui peut être enlevée sélectivement par rapport à la couche de renforcement (4).

3. Procédé selon la revendication 1 ou 2,
**caractérisé en ce**
**que** les couches de contact (3, 4) présentent au moins la double épaisseur de la couche active (2).

4. Procédé selon l'une quelconque des revendications 1 à 3,
**caractérisé en ce que**
la couche de support auxiliaire (5) est appliquée par voie galvanique.

5. Procédé selon l'une quelconque des revendications 1 à 4,
**caractérisé en ce qu'**
après l'enlèvement du substrat (1), des couches de contact (6) sont réalisées côté avant sur le côté de la couche active (2), opposé à la couche de support auxiliaire (5).

6. Procédé selon la revendication 1,
**caractérisé en ce**
**que** les puces à semi-conducteur (7) sont appliquées côté avant sur un film (8).
